# EUROPÄISCHE PATENTANMELDUNG

(11) **EP 1 895 392 A1**
(43) Veröffentlichungstag der Anmeldung: **05.03.2008**
(21) Anmeldenummer: 07114402.6
(22) Anmeldetag: 16.08.2007
(51) Int. Cl.: G06F 3/042, H03K 17/968

(54) **Vorrichtung zum Bedienen von Funktionen eines Gerätes**

(30) Priorität: 30.08.2006 DE 102006040572
(71) Anmelder: SIEMENS AKTIENGESELLSCHAFT, 80333 München (DE)
(72) Erfinder: Bösnecker, Robert, 84030 Ergolding (DE)

(57) **Zusammenfassung**

Die Erfindung beschreibt eine Vorrichtung (1) zum Bedienen von Funktionen eines Gerätes (2), mit Mitteln zum Erkennen einer auf oder oberhalb einer Bedienfläche (3) durch ein Bedienobjekt (4) ausgeführten Bediengestik, welche wenigstens einen Detektor (5a bis 5h) zum Erfassen einer Position des Bedienobjektes (4) relativ zur Bedienfläche (3) aufweist, wobei der wenigstens eine Detektor (5a bis 5h) eine Lichtquelle (6a) zum Aussenden von Licht (6) und einem Lichtsensor (6b) zum Registrieren von einfallendem Licht (6) umfasst. Um eine kostengünstige, robuste und störunanfällige Vorrichtung (1) zum Erfassen einer Bedienung zu erhalten, ist eine Vielzahl lokale Erfassungsbereiche (7a bis 7h) bildende Detektoren (5a bis 5h) an der Bedienfläche (3) angeordnet, wobei wenigstens ein Teil der Detektoren (5a bis 5h) zu einer einen funktionellen Erfassungsbereich (8) bildenden Detektorgruppe derart gekoppelt sind, dass deren Detektorsignale für die Bediengestikerkennung über einen Mikrocontroller ausgewertet werden können.

## Beschreibung

Die Erfindung bezieht sich auf eine Vorrichtung zum Bedienen von Funktionen eines Gerätes, mit Mitteln zum Erkennen einer auf oder oberhalb einer Bedienfläche durch ein Bedienobjekt ausgeführten Bediengestik, welche wenigstens einen Detektor zum Erfassen einer Position des Bedienobjektes relativ zur Bedienfläche aufweist, wobei der wenigstens eine Detektor eine Lichtquelle zum Aussenden von Licht und einen Lichtsensor zum Registrieren von einfallendem Licht umfasst.

Eine solche Vorrichtung ist beispielsweise in der deutschen Offenlegungsschrift DE 197 08 240 A1 offenbart. Es wird beschrieben, wie man mit Hilfe einer Infrarotkamera und einem Infrarotscheinwerfer eine Gestikerkennung zur Eingabe bei Computersystemen anwenden kann. Diese Vorrichtung stellt sehr hohe Anforderungen an ein Auswertesystem. Ein Bild der Infrarotkamera muss digitalisiert werden und eine komplexe Software auf einem zugehörigen Computersystem muss mehrere Male pro Sekunde das abgetastete Bild analysieren und mit den zuvor analysierten Bildern vergleichen und Zwischenstände abspeichern, um eine Gestik, beispielsweise eine Handbewegung, innerhalb eines Kamerabereiches erkennen zu können. Durch diese aufwendige Bildanalyse ist der Einsatz dieser Technik sehr kostspielig. Für den Einsatz in einfachen und kostengünstigen Geräten ist sie daher nicht geeignet.

Es ist Aufgabe der Erfindung eine Vorrichtung zum Bedienen von Funktionen eines Gerätes bereitzustellen, das die Nachteile des Standes der Technik vermeidet.

Die Aufgabe wird durch die eingangs genannte Vorrichtung dadurch gelöst, dass eine Vielzahl lokaler Erfassungsbereiche bildender Detektoren an der Bedienfläche angeordnet ist, wobei wenigstens ein Teil der Detektoren zu einer einen funktionellen Erfassungsbereich bildenden Detektorgruppe derart gekoppelt ist, dass deren Detektorsignale für die Bediengestikerkennung gemeinsam auswertbar sind. Die Auswertung der Detektorsignale für eine Bediengestik gestaltet sich nun einfacher als es beim Stand der Technik der Fall ist. Mittels der an der Bedienfläche angeordneten Detektoren bzw. Detektorgruppen kann eine Vielzahl von Positionen erfasst werden und die Positionen in ein der Bediengestik entsprechendes elektrisches Signal oder in eine Signalfolge umgesetzt werden. Die Signale oder Signalfolgen werden einer Gerätefunktion zugeordnet. Unter Bediengestik ist beispielsweise die Bewegung einer Hand und/oder eines Fingers und/oder eines Zeige-Gegenstandes zu verstehen. Die Bewegung der Bediengestik wird vorzugsweise willentlich ausgeführt und zeigt eine Interaktion zwischen einem Bediener und einer Maschine und/oder eines anderen Menschen an.

Eine Weiterbildung der Erfindung besteht darin, dass bei einer ersten Art von Detektoren die Lichtquelle und der Lichtsensor derart aufeinander ausgerichtet sind, dass ausgesendetes Licht geradlinig auf den Lichtsensor trifft. Es kann so ein großer lokaler Erfassungsbereich aufgespannt werden, weil der Abstand zwischen Lichtquelle und Lichtsensor, bei dieser Art der Sensoren, den lokalen Erfassungsbereich bildet. Der lokale Erfassungsbereich liegt somit annähernd in der Bedienfläche, wobei die Detektoren bei einer Licht-Strahl-Unterbrechung das Signal bzw. die Signalfolge generieren.

Weiterhin ist es vorteilhaft, dass bei einer zweiten Art von Detektoren die Lichtquelle und der Lichtsensor derart ausgerichtet sind, dass ausgesendetes Licht über eine Reflexion am Bedienobjekt auf den Lichtsensor trifft. Der lokale Erfassungsbereich bei der zweiten Art von Detektoren liegt vorzugsweise oberhalb der Bedienfläche. Zur Signalgenerierung genügt eine Annäherung des Bedienobjektes an die Bedienfläche. Für den Fall dass das ausgesendete Licht annähernd senkrecht auf der Bedienfläche "steht" kann mittels der zweiten Art von Detektoren zusätzlich eine Entfernung zum Bedienobjekt ermittelt werden. Die Detektoren generieren das Signal bzw. die Signalfolge, wenn das reflektierte Licht auf den Lichtsensor trifft.

Zweckmäßigerweise ist die Bedienvorrichtung derart ausgestaltet, dass die Bedienfläche optische oder haptische Führungsmittel für das Bedienobjekt aufweist. Mögliche Bedienwege oder Bewegungsabläufe einer Bediengestik können so vorgegeben werden und ermöglichen ein sicheres Erkennen der Bediengestik. Ein Bedienobjekt kann beispielsweise ein Finger eines menschlichen Bedieners, ein Zeigestock oder ein Stab sein. Da das Bedienobjekt in "vorgezeichneten" Wegen geführt werden kann, wird durch die Führungsmittel die Bedienung erleichtert und intuitiver.

In einer weiteren vorzugsweisen Ausgestaltung sind die Führungsmittel als Vertiefung und/oder Erhöhung und/oder Markierung an der Bedienfläche ausgebildet und eine Detektorgruppe ist entlang der Führungsmittel angeordnet. Eine relativ zur Bedienfläche punktuelle Vertiefung, insbesondere eine Mulde, insbesondere eine längliche Vertiefung oder Nut, zeigen dem Bediener in einer unmissverständlichen Art und Weise den möglichen Bedienweg auf.

Schließlich ist es vorteilhaft, wenn eine Detektorgruppe zur Erkennung von frei gestalteten Bedienzeichen in Matrixform angeordnet ist. Mittels der Matrixform, beispielsweise ein Schachbrettmuster, kann vorzugsweise ein gegenüber einer einzelnen Gestiklinie räumlich oder flächenmäßig erweiteter funktioneller Erfassungsbereich gebildet werden. Durch diesen funktionellen Erfassungsbereich lassen sich frei gestaltete Bedienzeichen, wie das "Schreiben" eines Buchstabens auf der Bedienfläche erkennen.

Weiterhin ist es zweckmäßig, das Mittel für eine akustische und/oder optische und/oder taktile Rückmeldung bei oder nach erfolgter Bedienung vorgesehen sind. Ein Signalgeber erzeugt beispielsweise ein Klicken, eine Signallampe erzeugt vorzugsweise einen Lichtblitz oder eine Art Lauflicht, welches beispielsweise mittels LEDs realisiert ist, folgt der Bediengestik. Durch diese Arten von Rückmeldungen wird dem Bediener angezeigt, dass seine Bedienung erfolgreich war.

In einer weiteren zweckmäßigen Ausgestaltung sind die Mittel für die taktile Rückmeldung als eine mit der Bedienfläche gekoppelte Schwingspule ausgebildet. Eine Berührung der Bedienfläche mit beispielsweise einem Finger fühlt sich dann sehr realistisch an und der Bediener merkt, dass er etwas auslöst oder verändert. Beispielsweise fühlt es sich für den Bediener so an, als hätte die vorzugsweise glatte Oberfläche kleine Hügel oder Buckel. Anstelle der Schwingspule können auch Vibratoren eingesetzt werden. Vibratoren erzeugen Vibrationen ähnlich dem Vibrationsalarm eines Funktelefones, welcher mittels eines Schrittmotors realisiert ist.

Vorzugsweise sind die Lichtquellen und Lichtsensoren der Detektoren zur Aussendung bzw. zum Empfang von Infrarotlicht ausgebildet. Da Infrarotlicht im nicht sichtbaren Bereich des Lichtes liegt, wird der Bediener nicht durch störende Lichtimpulse beeinflusst.

In einer vorteilhaften Weiterbildung ist ein Mikrocontroller zur Auswertung der Detektorsignale einer Detektorgruppe vorgesehen. Mittels des Mikrocontrollers kann so eine schnelle direkte Verarbeitung der durch die Detektoren bzw. Sensoren erzeugten Signale oder Signalfolgen erfolgen.

Weiterhin ist es zweckmäßig, dass der Mikrocontroller zum Erkennen einer Bewegungsrichtung und/oder einer Bewegungsgeschwindigkeit und/oder einer Bewegungsunterbrechung des Bedienobjektes ausgebildet ist. Hierbei ist es von Vorteil, dass der Mikrocontroller einen Vergleich mit bereits im Mikrocontroller hinterlegten Signalfolgen, welcher einer bestimmten Gestik entsprechen, durchführen kann.

Ferner ist es zweckmäßig, dass die Bedienfläche zumindest teilweise für das von den Detektoren verwendete Licht durchlässig ausgebildet ist. Mit dieser Art der Weiterbildung der Erfindung können die Detektoren unterhalb oder innerhalb der Bedienfläche angeordnet sein. Es ergibt sich damit auf vorteilhafte Art und Weise eine staub- und stoffdichte Ausführung der Bedienvorrichtung. Darüber hinaus lässt sich eine derart ausgestaltete Oberfläche leichter reinigen, welches der Vorrichtung bei einem Einsatz in einer schmutzerfüllten Umgebung Vorteile verschafft.

Eine weitere Steigerung der Bedienerfreundlichkeit der Bedienvorrichtung wird dadurch erreicht, dass unter einem lichtdurchlässigen Teil der Bedienfläche ein Fernbedienungsempfänger angeordnet ist. Dies bietet den Vorteil, dass eine Gestikerkennung und ein Fernbedienungsempfang hinter einer Bedienfläche bzw. einer Trennscheibe kombiniert werden kann. Hieraus ergeben sich hinsichtlich einer Formgebung gestalterische aber auch Platzbedarfsvorteile.

Die Erfindung wird im Folgenden noch anhand der in der Zeichnung auszugsweise und teilweise schematisch dargestellten Ausführungsbeispiele näher erläutert, es zeigen:
- FIG 1: eine Bedienvorrichtung mit einem funktionellen Erfassungsbereich,
- FIG 2: einen Detektor nach einer ersten Ausführungsart,
- FIG 3: einen Detektor nach einer zweiten Ausführungsart,
- FIG 4 bis 7: eine Anordnung und eine Wirkungsweise der Detektoren in der Bedienfläche,
- FIG 8: einen funktionellen Erfassungsbereich als "Schieberegler" und
- FIG 9: einen funktionellen Erfassungsbereich als "Drehregler".

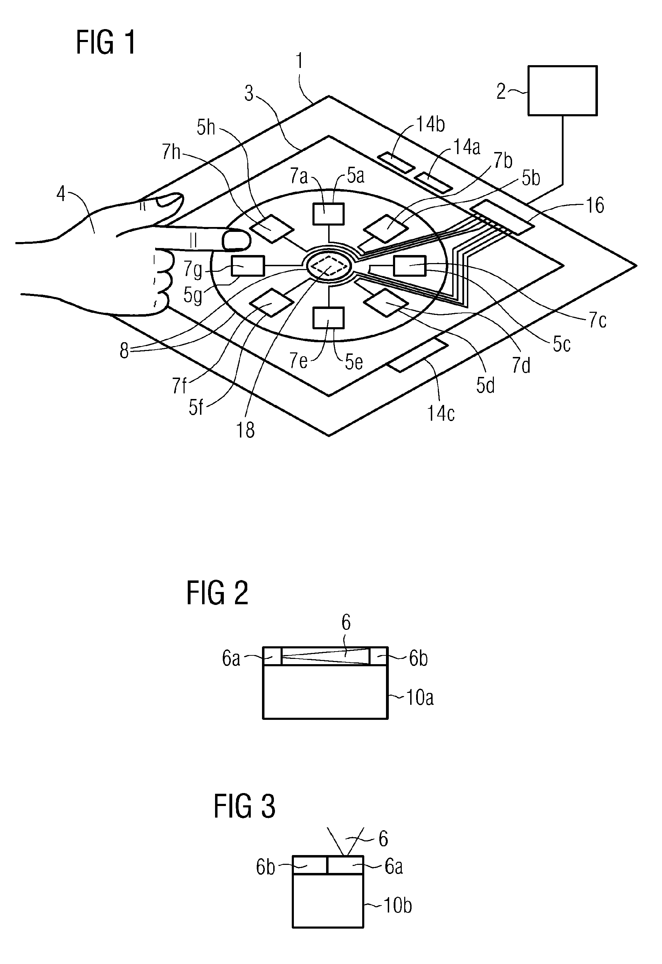

Figur 1 zeigt in einem ersten Ausführungsbeispiel eine Bedienvorrichtung 1 zum Bedienen von Funktionen eines Gerätes 2. Das Gerät 2 stellt in diesem Fall eine Steuerungseinheit für eine Klimaanlage dar und ist über eine Steuerleitung mit der Bedienvorrichtung 1 verbunden. Das Bedienen von Funktionen mit der Bedienvorrichtung 1, soll, abgesehen von diesem Beispiel, nicht ausschließlich für Klimaanlagen gelten, sondern für jegliche Art von elektrisch steuerbaren Geräten, wie z.B. ein Radio, ein Automatisierungsgerät, ein Computer, eine Beleuchtungsanlage, eine Kücheneinrichtung, eine Aufzugssteuerung usw.

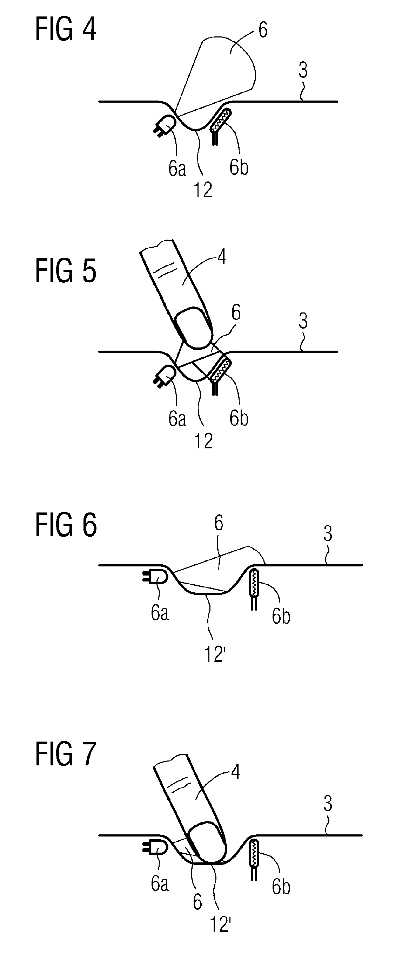

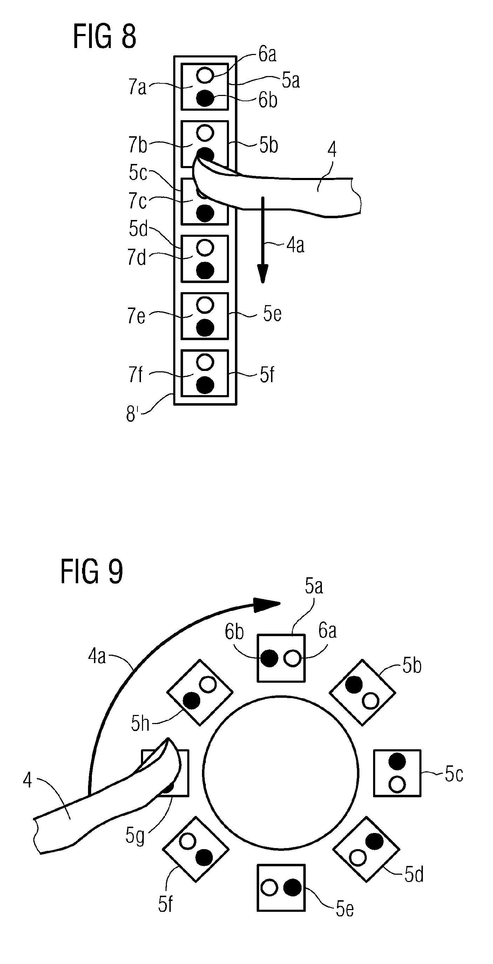

Die Bedienvorrichtung 1 ist als eine Tisch- oder Wandeinbauvariante in einer staub- und wasserdichten Ausführung ausgestaltet. Die Bedienvorrichtung 1 weist einen korrosionsbeständigen Metallrahmen auf, in welchem eine Bedienfläche 3 angeordnet ist. Die Bedienfläche 3 ist als eine bruchsichere, Infrarotlicht-durchlässige Glasscheibe ausgestaltet. Auf oder auch oberhalb der Bedienfläche 3 können mittels eines Bedienobjektes 4, hier ein Zeigefinger einer menschlichen Hand, Bedienungen ausgeführt werden. Zum Erkennen der Bedienung sind unterhalb der Bedienfläche 3 acht Detektoren 5a bis 5h kreisförmig angeordnet. Die Detektoren 5a bis 5h weisen, wie in Figur 3 und in Figur 8 dargestellt, je eine Lichtquelle 6a und je einen Lichtsensor 6b auf, wobei das Licht 6 aus der Lichtquelle 6a die Bedienfläche 3 nahezu senkrecht zu ihr durchdringt.

Die kreisförmige Anordnung der Detektoren 5a bis 5h bildet eine Detektorgruppe, die wiederum einen kreisförmigen funktionellen Erfassungsbereich 8 für das Bedienobjekt 4 bildet. Mittels je einer Datenleitung, welche je einen der Detektoren 5a bis 5h mit einem Mikrocontroller 16 verbindet, können deren Detektorsignale für die Bediengestikerkennung im Mikrocontroller 16 gemeinsam ausgewertet werden.

Der Mikrocontroller 16 ist derart ausgestaltet oder programmiert, dass er die ihm über die einzelnen Datenleitungen zugeführten Signale bzw. Signalfolgen, hervorgerufen durch die Bediengestik, einer Gerätefunktion zuordnet und an das Gerät 2 weiterleitet.

Will nun der Bediener mittels der Klimaanlagensteuerung eine Raumtemperatur erhöhen, so kann er mit seinem Finger den funktionellen Erfassungsbereich 8, welcher durch zwei Linien als ein Kreisring auf der Bedienfläche 3 abgebildet ist, im Uhrzeigersinn "abfahren". Dabei ist ein Startpunkt für das "Abfahren" mit dem Finger nicht entscheidend, denn vom Mikrocontroller wird die Anzahl der durch die Detektoren 5a bis 5h ausgelösten Signale ausgewertet und als ein neuer Sollwert mit Hilfe des Mikrocontroller 16 an die Klimaanlagensteuerung übergeben.

Um dem Bediener eine akustische und optische Rückmeldung über eine erfolgreich erkannte Bediengestik zu geben, sind im oberen Teil des Metallrahmens eine Signallampe 14b und ein akustischer Signalgeber 14a angeordnet. Die Signallampe 14b und der Signalgeber 14a werden, über nicht dargestellte Signalleitungen, über einen geeigneten Verstärker, welcher in dem Signalgeber 14a und in der Signallampe 14b integriert ist, mittels des Mikrocontrollers 16 angesteuert.

Angenommen, der Bediener startet seine Bediengestik an der Stelle der Bedienfläche 3, an der sich unterhalb der Glasscheibe der erste Detektor 5a befindet, so wird, sobald sich der Finger des Bedieners in einem ersten lokalen Erfassungsbereich 7a des Detektors 5a befindet, durch den Detektor 5a das erste Signal an den Mikrocontroller 16 weitergeleitet. In einem nächsten Schritt des Bewegungsablaufes der Bediengestik befindet sich der Finger über dem zweiten Detektor 5b und somit im zweiten lokalen Erfassungsbereich 7b. Der Bediener setzt seine Bediengestik über den dritten Detektor 5c, dem vierten Detektor 5d bis zum fünften Detektor 5e fort und gelangt dadurch nacheinander in einen dritten lokalen Erfassungsbereich 7c, in einen vierten lokalen Erfassungsbereich 7d und schließlich in einen fünften lokalen Erfassungsbereich 7e. Hier endet seine auf der Bedienfläche 3 ausgeführte Bediengestik. Durch das "Überfahren" der genannten fünf Erfassungsbereiche 7a bis 7e wurden dem Mikrocontroller 16 mittels der Detektoren 5a bis 5e fünf Impulse als Signale zugeleitet, welche er durch die Bewegungsrichtung im Uhrzeigersinn als eine Temperaturerhöhung auswertet, und der Klimaanlagensteuerung an eine Temperaturerhöhungsfunktion weiterleitet.

Während der zuvor beschriebenen Bediengestik wurden für jedes durch den Mikrocontroller 16 erkannte Signal, die Signallampe 14 und der Signalgeber 14a impulsmäßig aktiviert. Der Bediener wird durch die derartige Rückmeldung optisch und akustisch informiert. Neben der optischen und akustischen Rückmeldung ist zusätzlich an der Glasscheibe der Bedienfläche 3 ein Vibrator 14c, welcher auch als eine Schwingspule ausgeführt sein kann, angeordnet. Dieser Vibrator 14c gibt dem Bediener eine taktile Rückmeldung über seine Bedienung. Über den Vibrator 14c oder die Schwingspule wird, vorzugsweise für eine erkannte Teilgestik, ein basslastiges Audiosignal zur Ansteuerung verwendet. Die derart in Schwingung versetzte Bedienfläche 3 fühlt sich für den Bediener dann nicht mehr wie eine glatte Oberfläche an, sondern wie eine Oberfläche mit Hügeln oder Buckeln. Dem Bediener wird somit ein realistisches Bediengefühl gegeben und er kann realisieren, dass er etwas ausgelöst hat.

Zusätzlich zu den Detektoren 5a bis 5h ist unter der Glasscheibe ein Fernbedienungsempfänger 18 angeordnet. Dadurch können die Gestikerkennung und ein Fernbedienungsempfang hinter einer gemeinsamen Trennscheibe erfolgen. Dies bringt Vorteile hinsichtlich eines Designs für eine Frontseitengestaltung von Eingabevorrichtungen.

Analog zu der in Figur 1 kreisförmigen Anordnung der Detektoren 5a bis 5h und dem somit gebildeten ringförmigen funktionellen Erfassungsbereich 8 können die Detektoren auch als eine Matrix oder als ein Schachbrettmuster angeordnet sein und es kann mittels geeigneter Programmierung des Mikrocontrollers eine Vielzahl von beliebigen Erfassungsbereichen realisiert werden. Mit solch einem matrixförmigen Erfassungsbereich, können beispielsweise vom Bediener frei gestaltete Bedienzeichen erkannt werden. Unter frei gestaltete Bedienzeichen sind beispielsweise die Buchstaben des Alphabets zu verstehen. Auch ist ein zweidimensionaler Verlauf, vorzugsweise der Verlauf einer schlangenförmigen Bewegung, oder ein Verlauf beliebiger geometrischer Formen zu erkennen. Sind die Detektoren und der Mikrocontroller 16 zur Entfernungsmessung entsprechend hergerichtet, so kann auch ein dreidimensionaler Verlauf, beispielsweise ein zusätzliches Auf und Ab des Bedienobjektes 4, bei einem gleichzeitigen schlangenförmigen Verlauf erkannt werden. Bei dieser Art der Bediengestikerkennung kann eine Bedieneingabe vollkommen berührungslos zu der Bedienfläche 3 erfolgen. Es besteht keine mechanische oder galvanische oder kapazitive Kopplung zum Benutzer.

Figur 2 und Figur 3 zeigen zwei verschiedene Arten von Detektoren 10a und 10b. Bei einer ersten Art von Detektoren 10a sind, wie in Figur 2 zu sehen, die Lichtquelle 6a und der Lichtsensor 6b derart aufeinander ausgerichtet, dass das durch die Lichtquelle 6a ausgesendete Licht 6 geradlinig auf den Lichtsensor 6b trifft. Diese erste Art von Detektoren 10a wird für ein weiteres Ausführungsbeispiel einer Bedienfläche 3 wie in den Figuren 6 und 7 dargestellt, verwendet.

In Figur 3 ist eine zweite Art von Detektoren 10b dargestellt. Bei dieser Art von Detektoren 10b ist die Lichtquelle 6a und der Lichtsensor 6b derart ausgerichtet, dass das durch die Lichtquelle 6a ausgesendete Licht 6 über eine Reflexion am Bedienobjekt 4 auf den Lichtsensor 6b trifft. Diese Art von Detektoren 10b findet in dem Ausführungsbeispiel aus Figur 1 Anwendung.

Figur 4 und Figur 5 zeigen die Anwendung der ersten Art von Detektoren 10a. In diesem Ausführungsbeispiel einer Bedienfläche 3 weist die Bedienfläche 3 ein Führungsmittel für das Bedienobjekt 4 auf. Das Führungsmittel ist als eine längliche Nut oder Vertiefung 12 ausgestaltet. Der Bediener kann das Bedienobjekt 4 in dieser Nut sicher führen und vermeidet Fehleingaben. Wie in Figur 4 dargestellt, sendet die Lichtquelle 6a Licht 6 aus. Die Lichtquelle 6a und der Lichtsensor 6b sind derart angeordnet, dass das Licht 6 nur über eine Reflexion am Bedienobjekt 4, wie in Figur 5 dargestellt, zum Lichtsensor 6b gelangen kann. Das über das Bedienobjekt 4 reflektierte Licht 6 fällt in den Lichtsensor 6b ein und löst ein Detektorsignal aus.

Figur 6 und Figur 7 zeigen die Verwendung der zweiten Art von Detektoren 10b. Die Lichtquelle 6a und der Lichtsensor 6b sind derart aufeinander ausgerichtet, dass das von der Lichtquelle 6a ausgesendete Licht 6 gradlinig auf den Lichtsensor 6b fällt. Die Lichtquelle 6a und der Lichtsensor 6b sind derart in einem Kanal 12' angeordnet, dass durch das Führen des Bedienobjektes 4 im Kanal 12', der Lichtstrahl 6 unterbrochen wird und nicht mehr in den Lichtsensor 6b einfällt. Durch die Unterbrechung des Lichtes 6 mittels des Bedienobjektes 4 wird bei dieser Art von Detektoren 10b ein Detektorsignal ausgelöst.

Figur 8 zeigt in einem weiteren Ausführungsbeispiel einen länglichen, rechteckförmigen weiteren funktionellen Erfassungsbereich 8'. Der funktionelle Erfassungsbereich 8' bildet einen klassischen Schieberegler nach. Die Detektoren 5a bis 5f sind jeweils mit einer Lichtquelle 6a und einem Lichtsensor 6b, welcher einen Detektor der zweiten Art bilden, ausgestaltet. Die Detektoren 5a bis 5f sind hintereinander angeordnet und bilden mit ihren lokalen Erfassungsbereichen 7a bis 7f den Schieberegler. Dieser Schieberegler kann als ein Lautstärkeregler für ein Radiogerät benutzt werden. Durch das Bedienobjekt 4 kann durch eine Bewegung in einer Bedienrichtung 4a eine Verringerung der Lautstärke des Radiogerätes ausgeführt werden. Die Verschaltung mit dem in Figur 1 gezeigten Mikrocontroller 16 zu Detektorgruppen erfolgt analog zu dem in Figur 1 beschriebenen Ausführungsbeispiel.

Der in Figur 1 beschriebene kreisförmige funktionelle Erfassungsbereich 8 ist in Figur 9 nochmals detaillierter dargestellt. Durch das "Überfahren" der Sensoren 5a bis 5h mit dem Bedienobjekt 4 und der Bewegungsrichtung 4a kann ein Drehregler realisiert werden. Der im ersten Ausführungsbeispiel beschriebene Mikrocontroller 16 ist derart ausgestaltet, dass er ein drehen im und entgegen dem Uhrzeigersinn erkennen kann. Der Mikrocontroller kann anhand der Impulsfolge die Drehrichtung und die Geschwindigkeit des Bedienobjektes 4 erkennen. Kreist der Finger eines Bedieners, beispielsweise im Uhrzeigersinn, so wird das als Erhöhung, beispielsweise einer Lautstärke, für ein Radio interpretiert. Kreist der Finger des Bedieners hingegen gegen den Uhrzeigersinn, so wird eine Verringerung der Lautstärke interpretiert.

Ein weiteres, nicht dargestelltes Ausführungsbeispiel ist eine durch ein dreidimensionales Gebilde, beispielsweise eine Halbkugel, ausgestattete Bedienoberfläche.

## Patentansprüche

1. Vorrichtung (1) zum Bedienen von Funktionen eines Gerätes (2), mit Mitteln zum Erkennen einer auf oder oberhalb einer Bedienfläche (3) durch ein Bedienobjekt (4) ausgeführten Bediengestik, welche wenigstens einen Detektor (5a bis 5h) zum Erfassen einer Position des Bedienobjektes (4) relativ zur Bedienfläche (3) aufweist, wobei der wenigstens eine Detektor (5a bis 5h) eine Lichtquelle (6a) zum Aussenden von Licht (6) und einen Lichtsensor (6b) zum Registrieren von einfallendem Licht (6) umfasst,
**dadurch gekennzeichnet, dass** eine Vielzahl lokale Erfassungsbereiche (7a bis 7h) bildender Detektoren (5a bis 5h) an der Bedienfläche (3) angeordnet ist, wobei wenigstens ein Teil der Detektoren (5a bis 5h) zu einer einen funktionellen Erfassungsbereich (8) bildenden Detektorgruppe derart gekoppelt ist, dass deren Detektorsignale für die Bediengestikerkennung gemeinsam auswertbar sind.

2. Bedienvorrichtung (1) nach Anspruch 1,
wobei bei einer ersten Art von Detektoren (10a) die Lichtquelle (6a) und der Lichtsensor (6b) derart aufeinander ausgerichtet sind, dass ausgesendetes Licht (6) geradlinig auf den Lichtsensor (6b) trifft.

3. Bedienvorrichtung (1) nach einem der Ansprüche 1 bis 2,
wobei bei einer zweiten Art von Detektoren (10b) die Lichtquelle (6a) und der Lichtsensor (6b) derart ausgerichtet sind, dass ausgesendetes Licht (6) über eine Reflexion am Bedienobjekt (4) auf den Lichtsensor (6b) trifft.

4. Bedienvorrichtung (1) nach einem der Ansprüche 1 bis 3,
wobei die Bedienfläche (3) optische und/oder haptische Führungsmittel für eine Ausführung der Bediengestik durch das Bedienobjekt (4) aufweist.

5. Bedienvorrichtung (1) nach Anspruch 4,
wobei die Führungsmittel als Vertiefung (12) und/oder Erhöhung und/oder Markierung an der Bedienfläche (3) ausgebildet sind und eine Detektorgruppe entlang der Führungsmittel angeordnet ist.

6. Bedienvorrichtung (1) nach einem der Ansprüche 1 bis 5,
wobei eine Detektorgruppe zur Erkennung von frei gestalteten Bedienzeichen in Matrixform angeordnet ist.

7. Bedienvorrichtung (1) nach einem der Ansprüche 1 bis 6,
wobei Mittel (14a, 14b, 14c) für eine akustische und/oder optische und/oder taktile Rückmeldung bei oder nach erfolgter Bedienung vorgesehen sind.

8. Bedienvorrichtung (1) nach Anspruch 7,
wobei die Mittel (14c) für die taktile Rückmeldung als eine mit der Bedienfläche (3) gekoppelte Schwingspule ausgebildet sind.

9. Bedienvorrichtung (1) nach einem der Ansprüche 1 bis 8,
wobei die Lichtquellen (6a) und Lichtsensoren (6b) der Detektoren (5a bis 5f) zur Aussendung bzw. zum Empfang von Infrarotlicht ausgebildet sind.

10. Bedienvorrichtung (1) nach einem der Ansprüche 1 bis 9,
wobei ein Mikrocontroller (16) zur Auswertung der Detektorsignale einer Detektorgruppe vorgesehen ist.

11. Bedienvorrichtung (1) nach Anspruch 10,
wobei der Mikrocontroller (16) zum Erkennen einer Bewegungsrichtung (4a) und/oder einer Bewegungsgeschwindigkeit und/ oder einer Bewegungsunterbrechung des Bedienobjektes (4) ausgebildet ist.

12. Bedienvorrichtung (1) nach einem der Ansprüche 1 bis 11,
wobei die Bedienfläche (3) zumindest teilweise für das von den Detektoren (5a bis 5f) verwendeten Lichts (6) durchlässig ausgebildet ist.

13. Bedienvorrichtung (1) nach Anspruch 12,
wobei unter einem lichtdurchlässigen Teil der Bedienfläche (3) ein Fernbedienungsempfänger (18) angeordnet ist.
